# EUROPEAN PATENT SPECIFICATION

(11) **EP 1 736 565 B1**
(45) Date of publication and mention of the grant of the patent: **24.12.2008**
(21) Application number: 06445043.0
(22) Date of filing: 13.06.2006
(51) Int. Cl.: C23C 14/32, C23C 30/00

(54) **Method for depositing composite coatings for finishing of hardened steels**
Verfahren zur Herstellung einer Verbundbeschichtung für Endbearbeitung von gehärtetem Stahl
Procédé pour déposer un revetement composite pour finissage des aciers trempes

(30) Priority: 22.06.2005 SE 0501487
(43) Date of publication of application: 27.12.2006
(73) Proprietor: Seco Tools AB, 737 82 Fagersta (SE)
(72) Inventor: Sjölén, Jacob, 737 41 Fagersta (SE); Larsson, Tommy, 737 90 Ängelsberg (SE); Karlsson, Lennart, 737 33 Fagersta (SE)
(74) Representative: Taquist, Henrik Lennart Emanuel

(56) References cited:
- EP-A- 1 382 709
- EP-A- 1 422 311
- WO-A-20/05053887
- US-A1- 2002 048 696
- PATENT ABSTRACTS OF JAPAN vol. 2003, no. 12, 5 December 2003 (2003-12-05) & JP 2004 283930 A (NACHI FUJIKOSHI CORP), 14 October 2004 (2004-10-14)

## Description

### Background of the invention

The present invention relates to a method of making a cutting tool for machining by chip removal consisting of a substrate of cubic boron nitride based material and a hard and wear resistant refractory coating of which at least one layer comprises an Me-Si-X phase formed during the deposition either as a single phase or by codeposition together with other phases or the same phase with different chemical composition. The tool according to the invention is particularly useful in metal cutting applications where the chip thickness is small and the work material is hard, e.g. finishing of hardened steels.

Cubic boron nitride, cBN, has a hardness and thermal conductivity next to diamond and excellent characteristics such that reactivity with ferrous metals is lower than diamond. Cutting tools using a polycrystalline cubic boron nitride, PcBN, such as sintered bodies containing cBN are used instead of tools of cemented carbides or cermets when machining hardened steel, cast iron and nickel based alloys in order to improve the working efficiency.

PcBN sintered bodies for cutting tools comprise cBN particles and a binder. They are generally classified into the following two groups:
- Sintered bodies well-balanced in wear resistance as well as strength mainly used for hardened steels, comprising 30 to 80 volume % of cBN particles bonded through a binder predominantly consisting of Ti type ceramics such as TiN, TiC, Ti(C,N), etc.
- Sintered bodies excellent in thermal conductivity as well as strength mainly used for cast irons comprising 80 to 90 volume % of cBN particles directly bonded and the balance of a binder generally consisting of an Al compound or Co compound.

However, cBN particles have disadvantages that their affinity for ferrous metals is larger than TiN, TiC, Ti(C,N) binders. Accordingly, cutting tools employing cBN often have a shortened service life due to thermal abrasion, which eventually causes the tool edge to break. In order to further improve the wear resistance and fracture strength of a PcBN tool, it has been proposed to coat the PcBN tool with a layer of TiN, Ti(C,N), (Ti,Al)N, etc , e.g. US 5853873 and US 6737178.

However, a coated PcBN tool meets with a problem that an unexpected delamination of the layer often occurs.

It is a further object of the present invention to provide a method for depositing a coating on a cutting tool based on PcBN excellent in adhesive strength aimed for machining by chip removal of hardened steel or cast iron.

WO 2005/053887 discloses a surface-coated cutting tool having a base material and formed thereon, a coating, wherein the coating has a hard layer comprising a compound selected from among a nitride, a carbonitride, a nitroxide and a carbonitroxide of one or more first elements selected from the group consisting of metals belonging to 4a, 5a and 6a Groups of the Periodic Table and B, A1 and Si. The hard layer has a thickness of 0.5 to 15 µm, and a hardness according to the nano indentation method of 20 to 80 GPa.

EP-A-1382709 discloses a coating-film furnished coated tools that are lubricative while maintaining resistance to wear are realized by coated tools in which a plurality of coating films is furnished on a base part. Furnished as the coating are one or more layers of, respectively: a first layer composed of one compound selected from nitrides, carbides, carbonitrides, oxynitrides and carboxynitrides of TiSi; and a second layer composed of one compound selected from nitrides, carbides, carbonitrides, oxynitrides and carboxynitrides of one metal M selected from Ti, Cr, and TiCr. The first layer and second layers are laminated in alternation.

### Brief description of the drawings

Figure 1: CuKα X-ray diffraction pattern in θ-2θ geometry obtained from an as-deposited Ti_{0.77}Si_{0.23}N-layer on a PcBN substrate according to the invention. The indices in the figure refer to the NaCl-type structure of the coating i.e. (Ti,Si)N.
Figure 2: CuKα X-ray diffraction pattern using a constant gracing incident angle of 1° between primary beam and sample surface from an as-deposited Ti_{0.77}Si_{0.23}N-layer on a PcBN substrate according to the invention. The indices in the figure refer to the NaCl-type structure of the coating i.e. (Ti,Si)N.
Figure 3: SEM micrograph showing the structure of a PcBN material after conventional ion etching prior to coating.
Figure 4: SEM micrograph showing the structure of a PcBN material after ion etching according to the present invention prior to coating.

### Detailed description of the invention

The present invention relates to a method of growing at least one layer comprising (Me,Si)X phase on a PcBN substrate using physical vapour deposition (PVD). Additional layers are composed of nitrides and/or carbides and/or oxides from group 4-6 of periodic table.

The (Me,Si)X layer(s) comprise(s) crystals of Me₁₋ₐSiₐX_{b} phase, where Me is one or more of the elements Ti, Zr, Hf, V, Nb, Ta, Cr, and Al, preferably Ti, Cr, Zr and Al and a is between 0.05 and 0.4, preferably between 0.1 and 0.3, and X one or more of the elements N, C, O and B and b is between 0.5 and 1.1, preferably between 0.8 and 1.05.

The present invention thus relates to a method of growing layers comprising (Me,Si)X phase on a PcBN substrate.

First, an optimised surface condition is obtained by applying a soft Ar ion etching which enables good etching and cleaning of the cBN grains as well as the binder phase without decreasing the surface content of binder phase by preferential sputtering. The surface content of binder phase shall be equal to or higher than that of the bulk. The Ar ion etching is performed in an Ar atmosphere or in a mixture of Ar and H₂, whereby in the latter case a combined effect of physical sputtering and chemical etching is achieved, in a sequence of two and more steps where the average energy of impinging ions are successively decreased starting at a substrate bias, Vₛ<-500V to end with Vₛ>-150V. The intermediate step(s), if any, use -500V <Vₛ<-150V. Most preferably the applied substrate bias is pulsed with a frequency >5kHz with a bipolar voltage applied. The negative pulse is preferably > 80 % followed by a positive decharging pulse.

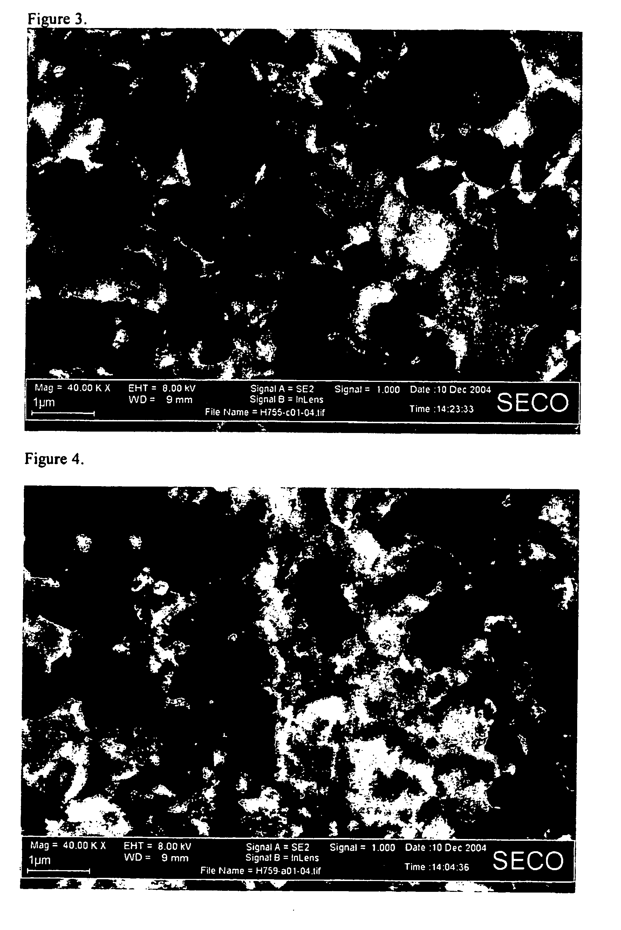

Figure 3 is a SEM micrograph showing the structure of a PcBN material with a NaCl-type structured binder phase after conventional ion etching prior to coating and Figure 4 after ion etching according to the present invention prior to coating. As can be seen when comparing Figures 3 and 4, the conventional ion etching removes too much of the binder phase thus exposing the cBN grains. The ratio L, defined as the fractional projected surface area of cBN, A_{cBN}, divided by the fractional volume of cBN, V_{cBN}, (L= A_{cBN}/ V_{cBN}), prior to deposition, is <1.15 preferably <1.0. The surface content of cBN in Figure 3 is 59% (L=1.18), and in Figure 4 49% (L=0.98), to be compared with the volume fraction of the bulk of 50%.

The optimum surface can also be obtained by chemical treatment and/or mechanical treatment such as a light blasting prior to deposition and/or in combination with an in-situ process in the deposition system.

In order to obtain the preferred structure of the layer according to the present invention several deposition parameters have to be fine-tuned. Factors influencing the deposition are the temperature in correlation to the energy of the impinging ions, which can be varied by the substrate bias, the cathode-substrate distance and the N₂ partial pressure, P_{N2}.

The method used to grow the layers comprising (Me,Si)X phase of the present invention, here exemplified by the system Ti₁₋ₓSiₓN, is based on arc evaporation of an alloyed, or composite cathode, under the following conditions:

The Ti+Si cathode composition is 60 to 90 at-% Ti, preferably 70 to 90 at-% Ti and balance Si.

The evaporation current is between 50 A and 200 A depending on cathode size and cathode material. When using cathodes of 63 mm in diameter the evaporation current is preferably between 60 A and 120 A.

The substrate bias is between -10 V and -150 V, preferably between -40 V and -70 V.

The deposition temperature is between 400°C and 700°C, preferably between 500°C and 700°C.

When growing layer(s) containing (Me,Si)X where X is N an Ar+N₂ atmosphere consisting of 0-50 vol-% Ar, preferably 0-20 vol-%, at a total pressure of 0.5 Pa to 9.0 Pa, preferably 1.5 Pa to 5.0 Pa, is used.

For the growth of (Me,Si)X where X includes C and O, C and/or O containing gases have to be added to the N₂ and/or Ar+N₂ atmosphere (e.g. C₂H₂, CH₄, CO, CO₂, O₂). If X also includes B it could be added either by alloying the target with B or by adding a B containing gas to the atmosphere.

The exact process parameters are dependent on the design and the condition of the coating equipment used. It is within the purview of the skilled artisan to determine whether the requisite structure has been obtained and to modify the deposition conditions in accordance to the present specification.

When growing layer(s) containing (Me,Si)X phase there is a risk that the compressive residual stress becomes very high which will influence the performance negatively in machining applications when sharp cutting edges are used and/or when the demand on good adhesion is of utmost importance. Residual stresses can be reduced by annealing in an atmosphere of Ar and/or N₂ at temperatures between 600°C and 1100°C for a period of 20 to 600 min.

Additionally, enhancement is obtained by adding a post-treatment, which improves the surface roughness of the cutting edge. This could be done by wet-blasting. Also, nylon brushes with embedded abrasive grains can be used. Another way is to move the coated PcBN tool through an abrasive medium such as tumbling or dragfinishing.

### Example 1

Polycrystalline cubic boron nitride (PcBN) inserts of type RCGN0803M0S with cBN volume fraction of 50% with an average grain size of 1 µm and a binder phase consisting of Ti(C,N) were cleaned in ultrasonic baths using alkali solution and alcohol and subsequently placed in the PVD-system using a fixture of threefold rotation. The shortest cathode-to-substrate distance was 160 mm. The system was evacuated to a pressure of less than 2.0×10⁻³ Pa, after which the inserts were sputter cleaned with Ar ions. A bi-polar pulsed process was used where the substrate bias changed between -Vₛ (80%) and +50V (20%) for one period with a frequency of 20kHz. Vₛ was in the beginning of the process -550 V and subsequently stepped down to -120 V in the end. Figure 4 shows the appearance of the PcBN surface after etching using this process.

Variant A was grown using arc evaporation of Ti_{0.75}Si_{0.25} cathodes, 63 mm in diameter and variant B using Ti_{0.80}Si_{0.20} cathode. The deposition was carried out in a 99.995% pure N₂ atmosphere at a total pressure of 4.0 Pa, using a substrate bias of -110 V for 60 minutes. The deposition temperature was about 530°C. Immediately after deposition the chamber was vented with dry N₂. As reference a state of the art coating, Ti_{0.34}Al_{0.66}N, was used and an uncoated variant.

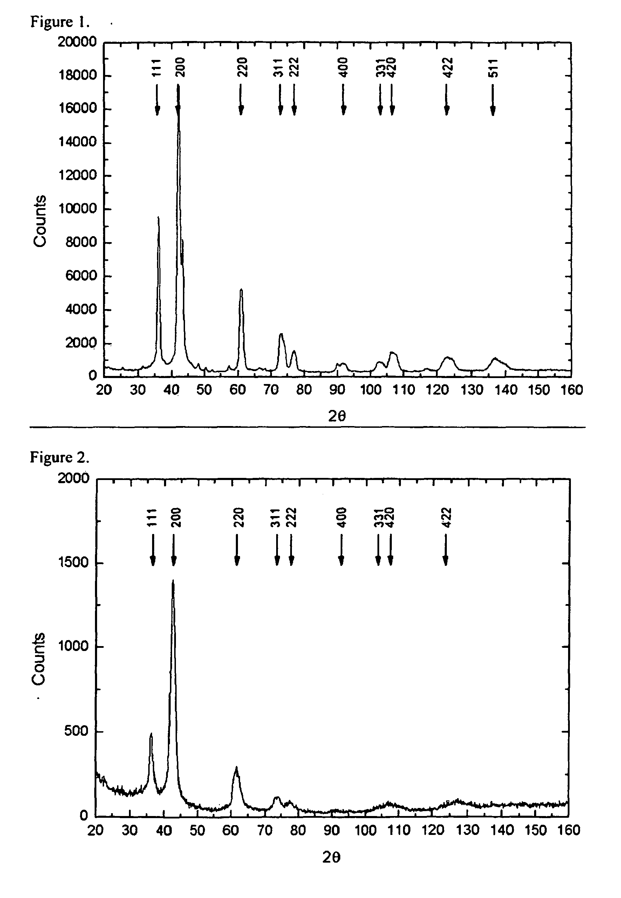

The X-ray diffraction patterns of the as-deposited Ti₁₋ₓSiₓN layer plus a TiN layer are shown in Figure 1 and Figure 2. Apart from the peaks corresponding to the PcBN substrates, the only peaks appearing are those corresponding to a cubic NaCl type Ti₁₋ₓSiₓN phase and a cubic NaCl type TiN phase as seen by the identification of the (111), (200), (220), (311), (222), (400), (331), (420), (422), and (511) peaks. The texture, defined as the ratio (K) between the area of the (Me,Si)X (111) peak and the (Me,Si)X (200) peak, is for this variant 0.28. The FWHM of the (Me,Si)X (111) peak is 1.30 °2θ and of the (Me,Si)X (200) peak 1.44 °2θ.

Phase identification of the Ti₁₋ₓSiₓN in as-deposited condition was made by X-ray diffraction using a constant gracing incident angle of 1° between primary beam and sample surface and scanning the detector in order to magnify peaks originating from the coating, see Figure 2. The presence of Ti₁₋ₓSiₓN is confirmed by the indexing of the diffraction pattern in the NaCl type structure.

The peak-to-background ratio for the Ti₁₋ₓSiₓN (200) peak was 24.

The thickness at the cutting edge was 1.0 µm of the Ti₁₋ₓSiₓN layer using scanning electron microscope (SEM) on a cross-section.

The unit cell parameter of (Ti_{0.77}Si_{0.23})N was 4.29 Å, of the PcBN binder phase consisting of Ti(C,N) phase 4.30 Å and 4.14 Å of Ti_{0.34}Al_{0.66}N.

The Vickers hardness of the layers was measured by nanoindentation using a Nano Indenter^{™} II instrument on polished tapered cross-sections using maximum load of 25 mN resulting in a maximum penetration depth of about 200 nm. The hardness is reported in Table 1. It can be seen from Table 1 that the hardness increases drastically when Si is present in the layer compared to a Ti_{1-y}Al_{y}N variant.

**Table 1.**

| Variant | Hardness (GPa) | Phases detected | FWHM (111) °2θ | FWHM (200) °2θ | Texture parameter K |
|---|---|---|---|---|---|
| A | 48 | Ti_{0.77}Si_{0.23}N, TiN | 1.30 | 1.44 | 0.28 |
| B | 45 | Ti_{0.82}Si_{0.18}N, TiN | 1.18 | 1.20 | 0.34 |
| C | 32 | Ti_{0.34}Al_{0.66}N, TiN | - | - | - |
| D | - | Uncoated | - | - | - |

### Example 2

The coated cutting tool inserts from Example 1 consisting of polycrystalline cubic boron nitride (PcBN) inserts of type RCGN0803M0S were tested in a finishing operation on case hardened gear wheels. The cutting data used was as follows:
- Material: SAE 5120 (20MnCr5), 59-61 HRC
- v_{f}= 190 m/min
- aₚ = 0.10 mm
- fₙ = 0.07 mm/rev.

The tool life criterion was number of gear wheels machined giving a minimum buoyancy level of 75% for the machined parts. The results are found in Table 2.

**Table 2.**

| Variant | Number of machined parts |
|---|---|
| A | 525 |
| B | 500 |
| C | 200 |
| D | 80 |

This test shows that variants A and B (this invention) can machine the highest number of parts followed by variant C.

### Example 3

Cutting tool inserts of wiper style coated similarly as in Example 1 consisting of polycrystalline cubic boron nitride (PcBN) inserts of type CNGA120408S-L1-WZ in a finishing operation of a case hardened gearshaft. The cutting data used was as follows:
- Material: SAE 5115 (16MnCrS5), 58 HRC
- v_{f}= 190 m/min
- aₚ = 0.15/0.35 mm
- fₙ = 0.3 mm/rev.

The tool life criterion was number of gearshafts machined giving a maximum surface roughness. The results are found in Table 3.

**Table 3.**

| Variant | Number of machined parts |
|---|---|
| A | 236 |
| C | 170 |

This test shows that variants A (this invention) can machine the highest number of parts.

### Example 4

Cutting tool inserts coated similarly as in Example 1 consisting of polycrystalline cubic boron nitride (PcBN) inserts of type CNGA120408S-L0-B in on through hardened socket. The cutting data used was as follows:
- Material: SAE 52100 (100Cr6), 63 HRC
- v_{f}=220 m/min
- aₚ=0.11/0.15 mm
- fₙ= 0.3 mm/rev.

The tool life criterion was number of sockets machined giving a maximum surface roughness. The results are found in Table 4.

**Table 4.**

| Variant | Number of machined parts |
|---|---|
| B | 175 |
| C | 124 |

This test shows that variants B (this invention) can machine the highest number of parts.

## Claims

1. Method of producing a coated cutting tool insert, solid end mill, or drill comprising a substrate of polycrystalline cubic boron nitride (PcBN) based material and a coating, the coating being composed of one or more layers of refractory compounds of which at least one layer comprises a Me₁₋ₐSiₐX_{b} phase described with the composition Me₁₋ₐSiₐX_{b} where Me is one or more of the elements Ti, V, Cr, Zr, Nb, Mo, Hf, Ta and Al, and a is between 0.05 and 0.4, preferably between 0.1 and 0.3, and X one or more of the elements N, C, O and B and b is between 0.5 and 1.1, preferably between 0.8 and 1.05, X containing less than 30 at-% of O + B is deposited using arc evaporation technique at an evaporation current of 50-200 A, a substrate bias of-10 - -150 V, a temperature of 400-700 °C, a total pressure of 0.5-9 Pa whereby the surface to be coated is pretreated by Ar ion etching performed in a sequence of two and more steps **characterised in** starting at a substrate bias, Vs<-500V and ending with Vs>-150 to obtain a surface with a lower fractional projected surface area of the cBN phase compared to the fractional volume of the cBN the ratio L, defined as the fractional projected surface area of cBN, A_{cBN}, divided by the fractional volume of cBN, V_{cBN}, (L= A_{cBN}/V_{cBN}), prior to deposition, being <1.15, preferably <1.0.

## Patentansprüche

1. Verfahren zum Herstellen eines beschichteten Schneidwerkzeugeinsatzes, Vollhartmetallschaftfräsers oder -bohrers, welcher ein Substrat aus einem auf polykristallinem kubischem Bornitrid (PcBN) basierenden Material und eine Beschichtung umfaßt, wobei die Beschichtung aus einer oder mehreren Lagen von widerstandsfähigen Verbindungen besteht, von denen wenigstens eine Lage eine Me₁₋ₐSiₐX_{b}-Phase mit der Zusammensetzung Me₁₋ₐSiₐX_{b} umfaßt, wobei Me eines oder mehrere der Elemente Ti, V, Cr, Zr, Nb, Mo, Hf, Ta und Al Ist und a zwischen 0,05 und 4, bevorzugt zwischen 0,1 und 0,3, beträgt und X eines oder mehrere der Elemente N, C, O und B ist und b zwischen 0,5 und 1,1, bevorzugt zwischen 0,8 und 1,05, beträgt, wobei X, welches weniger als 30 At.-% O + B enthält, mittels Lichtbogenverdampfungstechnik bei einem Verdampfungsstrom von 50-200 A, einer Substratvorspannung von -10 bis -150 V, einer Temperatur von 400-700°C und einem Gesamtdruck von 0,5-9 Pa abgeschieden wird, wobei die zu beschichtende Oberfläche mittels Ar-lonenätzung vorbehandelt wird, die in einer Abfolge von zwei und mehr Stufen durchgeführt wird, **gekennzeichnet durch** Starten bei einer Substratvorspannung Vs < -500 V und Beenden mit Vs > -150, um eine Oberfläche mit einer geringer partiell vorspringenden Oberfläche der cBN-Phase im Vergleich zum partiellen Volumen des cBN zu erhalten, wobei das Verhältnis L, definiert als die partiell vorspringende Oberfläche von cBN, A_{cBN}, geteilt **durch** das partielle Volumen von cBN, V_{cBN}, (L = A_{cBN}/V_{cBN}), vor dem Abscheiden von < 1,15, bevorzugt < 1,0, ist.

## Revendications

1. Procédé de production d'une plaquette d'outil de coupe revêtue, d'une fraise de bout plein, ou d'un foret, comprenant un substrat d'un matériau à base de nitrure de bore cubique polycristallin (PcBN) et un revêtement, le revêtement étant composé d'une couche ou plus de composés réfractaires dont au moins une couche comprend une phase Me₁₋ₐSiₐX_{b} décrite avec la composition Me₁₋ₐSiₐX_{b}, où Me est un élément ou plus parmi Ti, V, Cr, Zr, Nb, Mo, Hf, Ta et Al, et a est compris entre 0,05 et 0,4, de préférence entre 0,1 et 0,3, et X est un élément ou plus parmi N, C, O et B et b est compris entre 0,5 et 1,1, de préférence entre 0,8 et 1,05, X contenant moins de 30% atomique de O+B est déposé en utilisant une technique d'évaporation par are à un courant d'évaporation de 50-200 A, une polarisation de substrat de -10 à -150 V, une température de 400-700 °C, une pression totale de 0,5-9 Pa, la surface à revêtir étant prétraitée par décapage aux ions Ar réalisé dans une séquence de deux étapes ou plus, **caractérisé par** les étapes consistant à commencer par une polarisation de substrat, Vs<-500 V et terminer avec Vs>-150 pour obtenir une surface avec une aire de surface projetée fractionnaire de la phase cBN inférieure comparée au volume fractionnaire du cBN, le taux L, défini comme l'aire de surface projetée fractionnaire de cBN appelée A_{cBN}, divisée par le volume fractionnaire de cBN appelé V_{cBN}, (L = A_{cBN}/V_{cBN}), avant le dépôt, étant <1,15, de préférence <1,0.
